**Europäisches Patentamt**

**European Patent Office**

**Office européen des brevets**

(19)

(11) Veröffentlichungsnummer: **0 088 924**
**A2**

(12) # EUROPÄISCHE PATENTANMELDUNG

(21) Anmeldenummer: **83101903.9**

(22) Anmeldetag: **26.02.83**

(51) Int. Cl.³: **H 01 L 25/04**

(30) Priorität: **13.03.82 DE 3209173**

(43) Veröffentlichungstag der Anmeldung:
**21.09.83 Patentblatt 83/38**

(84) Benannte Vertragsstaaten:
**FR GB IT NL**

(71) Anmelder: **BROWN, BOVERI & CIE Aktiengesellschaft**
**Kallstadter Strasse 1**
**D-6800 Mannheim 31(DE)**

(72) Erfinder: **Weimann, Klaus, Dipl.-Ing.**
**Wierdenstrasse 19**
**D-6840 Lampertheim(DE)**

(72) Erfinder: **Baab, Hans-Joachim, Ing. grad.**
**Albrecht-Dürer-Ring 31**
**D-6710 Frankenthal(DE)**

(74) Vertreter: **Kempe, Wolfgang, Dr. et al,**
**c/o Brown, Boveri & Cie AG Postfach 351**
**D-6800 Mannheim 1(DE)**

(54) Halbleiterbauelement in Modulbauweise.

(57) Das Halbleiterbauelement mit den Eigenschaften eines rückwärtsleitenden Thyristors ist in Modulbauweise aufgebaut. Auf einer Bodenplatte (B) sind ein Halbleiterchip (T) mit den Eigenschaften eines Thyristors und wenigstens ein weiterer Halbleiterchip (D1,D2) mit den Eigenschaften einer Diode aufgelötet oder druckkontaktiert und mit Bonddrähten (D) oder sonstigen Verbindungsdrähten induktivitätsarm untereinander antiparallel verschaltet. Zur Verbindung mit der Außenwelt sind äußere Anschlußelemente (A,K,G) vorgesehen. Elektrische Eigenschaften der Halbleiterchips können unabhängig voneinander auf den speziellen Anwendungsfall optimiert werden. Das Stromleitvermögen der Dioden im Verhältnis zum Stromleitvermögen des Thyristors (T) kann durch Anzahl und Große der Diodenchips (D1,D2) in weiten Grenzen variiert werden.

Fig. 1

B R O W N , B O V E R I & C I E    AKTIENGESELLSCHAFT

Mannheim                                    6. Dez. 1982

Mp.-Nr. 683/82                            ZPT/P3-Bi/Bt

## Halbleiterbauelement in Modulbauweise

Die Erfindung betrifft ein Halbleiterbauelement in Modulbauweise, bestehend aus mehreren, untereinander elektrisch verschalteten, räumlich benachbart angeordneten Halbleiterchips und äußeren Anschlußelementen zur Verbindung des Halbleiterbauelements mit der Außenwelt.

Derartige Halbleitermodule sind handelsüblich. Bekannt sind Module, bei denen zwei, vier oder sechs Halbleiterchips in einem einzigen Gehäuse vereinigt sind. Die Halbleiterchips können je nach Anforderung die Eigenschaften von Thyristoren und/oder Dioden besitzen. Die Verschaltung der Halbleiterelemente im Inneren des Gehäuses kann als Halb- oder Vollbrücke für die gesteuerte oder ungesteuerte Gleichrichtung von Wechsel- oder Drehstrom sein. Andere Module enthalten antiparallel geschaltete Thyristoren für die Anwendung in Wechselstromstellern oder einen Thyristor und eine Diode für die Anwendung in sperrspannungsfreien Wechselrichterschaltungen.

Es sind auch schon Modulbauformen bekannt, bei denen die Halbleiterchips im Inneren des Gehäuses nur teilweise untereinander verschaltet sind, während die restlichen Anschlüsse getrennt aus dem Gehäuse herausgeführt sind. Bei diesen Ausführungsformen erfolgt die endgültige Verschaltung je nach dem gewünschten Anwendungszweck durch den Benutzer.

Setzt man einen derartigen handelsüblichen Modul, der in einem Gehäuse einen Thyristor und eine Diode enthält, beim Aufbau von Wechselrichtern in sperrspannungsfreier Schaltung ein, bei der jedem Thyristor eine Diode antiparallel geschaltet ist, so zeigt eine derartige Schaltung folgende Nachteile:

Der Durchlaßspannungsabfall im Thyristor ist unnötig hoch, bedingt durch die bei dieser Schaltung nicht ausgenützte Eigenschaft des Thyristors, Spannungen auch in der Rückwärtsrichtung zu sperren.

Die maximal mögliche Schaltfrequenz ist reduziert, bedingt durch die Eigeninduktivitäten in den Zuleitungen zu den Dioden.

Um die beschriebenen Nachteile beseitigen zu können, werden Thyristor und antiparallele Diode in einem einzigen Siliziumchip integriert zu einem sogenannten rückwärtsleitenden Thyristor. Im Zentrum des Siliziumchips befindet sich der Thyristor, dem jedoch die tiefdiffundierte p-Schicht auf der Anodenseite fehlt, da er nur Spannungen in Blockierrichtung, jedoch nicht in Sperrichtung sperren muß. Dadurch wird die Gesamtdicke der Silizium-Tablette verringert. Die Diode ist als Ring um den zentralen Thyristorteil herumgelegt. Bei dieser integrierten Anordnung sind Thyristor und Diode optimal nahe beieinander, so daß praktisch keine Leitungsinduktivitäten auftreten. Dieser Vorteil wird jedoch durch den Nachteil erkauft, daß wegen der gemeinsamen Herstellung von Thyristor und Diode im selben Diffusionsprozeß Diode und Thyristor nicht getrennt optimiert werden können. So ist beispielsweise die Ladungsträgerlebensdauer in beiden Teilen gleich groß, obwohl in der Diode eine geringe Ladungsträgerlebensdauer von Vorteil wäre. Außerdem sind die Stromleitfähigkeiten von Dioden- und Thyristorteil durch die Flächenverhältnisse fest vorgegeben; sie kann für bestimmte Anwendungsfälle zu gering, für andere Anwendungsfälle wieder unnötig groß sein. Außerdem ist die Ausbeute bei der Herstellung integrierter Halbleiterschaltungen naturgemäß geringer als bei der Herstellung von Einzelhalbleitern.

Ein weiterer Nachteil ergibt sich aus dem sogenannten snap-off-Verhalten des Diodenteils der rückwärtsleitenden Thyristoren. Man versteht darunter das plötzliche Abreißen des Rückstromes nach einer Stromumkehr, wodurch in der angeschlossenen Schaltung für den antiparallelen Thyristor Spannungsspitzen und hohe Spannungsanstiegsgeschwindigkeiten auftreten oder gar Ausgleichsschwingungen angeregt werden. Erwünscht wäre ein asymptotisches Abklingen des Rückstromes.

Der vorliegenden Erfindung liegt die Aufgabe zugrunde, ein Halbleiterbauelement der eingangs genannten Art anzugeben, welches die Eigenschaften eines rückwärtsleitenden Thyristors aufweist, jedoch ohne Halbleiterintegrationstechnik hergestellt werden kann.

Diese Aufgabe wird dadurch gelöst, daß ein Halbleiterchip mit den Eigenschaften eines Thyristors und wenigstens ein Halbleiterchip mit den Eigenschaften einer Diode induktivitätsarm antiparallel verschaltet sind.

Damit ergeben sich die Vorteile, daß Thyristorchip und Diodenchip jeweils getrennt optimiert und auf den jeweiligen Anwendungsfall hin abgestimmt gepaart werden können. Insbesondere können sehr schnell schaltende Dioden
eingesetzt werden.

Durch die Verwendung mehrerer Diodenchips antiparallel
zu einem Thyristorchip kann die Stromleitfähigkeit von
Thyristor- und Diodenteil an die Schaltungserfordernisse
angepaßt werden. Aus der Literatur ist bekannt, daß eine
Vielzahl von parallelgeschalteten Dioden strommäßig
höher überlastbar ist als eine Diode, die eine einzige
große Siliziumscheibe enthält.

Gemäß einer vorteilhaften Weiterbildung sind die Halbleiterchips räumlich nah nebeneinander auf einer Bodenplatte aufgelötet und untereinander verschaltet. Diese
Anordnung führt zu optimal kurzen und damit optimal induktivitätsarmen Zuleitungen zu den Diodenchips, wodurch
die auf von der Schaltungsinduktivität zwischen Diode
und Thyristor beeinflußte Freihaltezeit des Thyristors
minimal wird.

Gemäß einer bevorzugten Ausgestaltung der Erfindung ist
der Halbleiterchip ein Rückwärts-Nicht-Sperrender-Thyristor. Als Alternative hierzu bietet es sich an, den
Halbleiterchip als Gate-Turn-Off-Thyristor und die Diode
als schnelle Diode auszubilden. In beiden Fällen gelingt
es, mit Hilfe des erfindungsgemäßen Moduls Schaltungen
der Leistungselektronik aufzubauen, deren Leistungshalbleiter nur eine minimale Anzahl von äußeren Verbindungsstellen besitzt, und deren elektrische Eigenschaften
gegenüber den nach der bisherigen Schaltungstechnik
erreichbaren erheblich verbessert ist.

Vorzugsweise sind mehrere Halbleiterchips mit den Eigenschaften einer Diode vorgesehen, wobei ein Anschluß gegebenenfalls einer Diode an ein gesondertes äußeres An-

683/82 5

schlußelement gelegt ist. Bei einer derartigen Ausführungsform kann der Anwender selbst das Verhältnis der Stromleitfähigkeiten von Thyristor- und Diodenteil zueinander beeinflussen, ohne daß die Induktivität der Diodenzuleitungen untragbar hoch wird. Außerdem kann auf diese Weise eine gewisse Reparaturfähigkeit des Halbleiterbauelements erreicht werden.

Weitere Ausgestaltungen und Vorteile der Erfindung ergeben sich aus der nachfolgenden Beschreibung von Ausführungsbeispielen anhand der Zeichnung.

Es zeigen:

Fig. 1    eine Draufsicht auf einen Modul mit drei Halbleiterchips, der einen Rückwärts-Leitenden-Thyristor simuliert,

Fig. 2    das elektrische Ersatzschaltbild eines Halbbrückenmoduls mit Rückwärts-Leitenden-Thyristoren,

Fig. 3    eine Draufsicht auf einen Modul mit drei Halbleiterchips, der einen Rückwärts-Leitenden-GTO simuliert,

Fig. 4    ein erstes elektrisches Ersatz-Schaltbild eines Halbbrückenmoduls mit GTO,

Fig. 5    ein zweites elektrisches Ersatz-Schaltbild eines Halbbrückenmoduls mit GTO und

Fig. 6    eine Draufsicht auf einen Halbbrückenmodul mit zwei GTO und zwei Dioden.

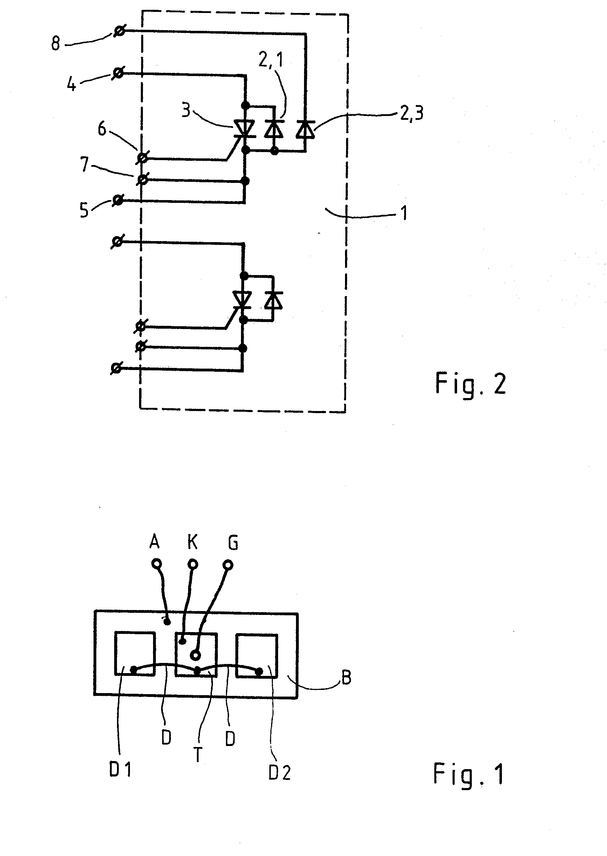

In Fig. 1 erkennt man eine Bodenplatte B, die gleichzeitig der Stromzufuhr sowie der Wärmeabfuhr dient. Auf die Bodenplatte B ist ein Halbleiterchip T mit den Eigenschaften eines rückwärts nicht sperrenden Thyristors aufgelötet. Rechts und links des Thyristorchips T befinden sich je ein Halbleiterchip D1,D2 mit den Eigenschaften einer Diode. Die Verbindung zwischen den Halbleiterchips T, D1, D2 auf der der Bodenplatte B abgewandten Seite erfolgt z.B. über Bonddrähte D. Die Verbindung mit äußeren Anschlußklemmen A für die Anode, K für die Kathode und G für die Steuerelektrode erfolgt in herkömmlicher Weise. Der Chipaufbau kann auch isoliert erfolgen.

In Fig. 2 erkennt man innerhalb eines Gehäuses 1, welches durch eine gestrichelte Linie symbolisiert ist, einen ersten rückwärts nicht sperrenden Thyristor 3, dem eine erste Diode 2.1 direkt und eine zweite Diode 2.3 nur halbseitig antiparallel geschaltet sind. Anode und Kathode des rückwärts nicht sperrenden Thyristors 3 sind an Anschlußelemente 4 bzw. 5 geführt. Die Steuerelektrode ist an ein äußeres Anschlußelement 6, die Hilfskathode an ein äußeres Anschlußelement 7 geführt. Der Kathodenanschluß der zweiten Diode 2.3 ist an ein getrenntes äußeres Anschlußelement 8 geführt.

Das untere Halbleiterbauelement entspricht in Aufbau und Anschlußbelegung dem soeben beschriebenen, wobei jedoch der Übersichtlichkeit halber die zweite Diode mit dem gesonderten äußeren Anschlußelement weggelassen wurde.

Es soll noch erwähnt werden, daß das erfindungsgemäße Halbleiterbauelement nicht nur in der dargestellten Form Verwendung finden kann, sondern daß vielmehr auch Thyristorchips verwendet werden können, die einen separaten Steueranschluß zum schnelleren Ausräumen der Ladungsträger und zur Verkleinerung der Freihaltezeit des Thyristors – sogenannter GATO = Gate Assisted Turn Off – besitzen.

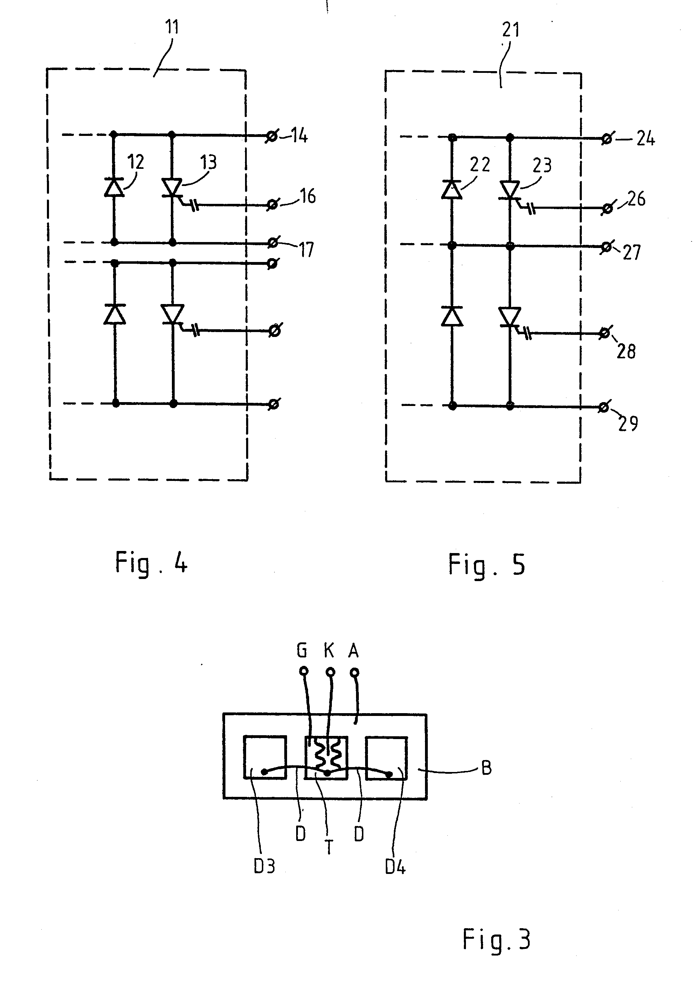

In Fig. 3 erkennt man einen in gleicher Weise wie in Fig. 1 aufgebauten Modul. Auf der Bodenplatte B ist ein Halbleiterchip T mit den Eigenschaften eines Gate-Turn-Off-Thyristors (GTO) aufgelötet. Anstelle des GTO-Thyristors kann auch ein Transistor vorgesehen werden. Daneben befinden sich Halbleiterchips D3,D4 mit den Eigenschaften einer schnellen Diode, z.B. einer Epi-Diode.

Fig. 4 zeigt innerhalb eines Gehäuses 11, welches durch eine gestrichelte Linie symbolisiert ist, einen ersten GTO-Thyristor 13, dem eine Diode 12 antiparallel geschaltet ist. Anode und Kathode des GTO-Thyristors 13 sind an äußere Anschlußelemente 14,17 geführt. Die Steuerelektrode des GTO-Thyristors ist an ein äußeres Anschlußelement 16 geführt. Die untere Hälfte des Halbbrückenmoduls entspricht in Aufbau und Anschlußbelegung dem soeben beschriebenen. Obere und untere Hälfte sind galvanisch getrennt.

Fig. 5 zeigt eine Anordnung, die der in Fig. 4 gezeigten entspricht; die obere und untere Hälfte der Halbbrücke sind hier jedoch galvanisch verbunden; die Kathode des oberen GTO-Thyristors 23 ist galvanisch mit der Anode des unteren GTO-Thyristors verbunden. Es sind weitere Ausführungsvarianten möglich, z.B. können beide Kathoden und Anoden jeweils miteinander verbunden sein.

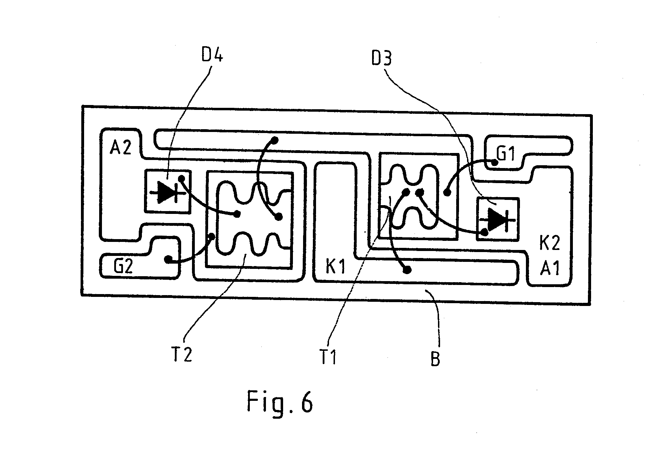

In Fig. 6 erkennt man eine mögliche Realisierung eines Halbbrückenmoduls mit zwei GTO-Thyristoren entsprechend Fig. 5. Jeder Halbleiterchip T1,T2 ist mit seiner Anodenseite auf einer Metallisierung aufgelötet, die mit A1 bzw. A2 gekennzeichnet ist. Unmittelbar neben einem Thyristor-Chip sind Halbleiterchips D3, D4, die als schnelle Diode wirken, mit ihrer Kathodenseite auf den Metallisierungen A1, A2 aufgelötet. Die elektrische Verschaltung der Halbleiterchips untereinander sowie mit den zugehörigen Metallisierungen für die Kathode bzw. die Steuerelektroden erfolgt mit Hilfe von Bonddrähten. Zu bemerken ist noch, daß die Flächen der Metallisierungen, an die die Anoden A1, A2 und die Kathode K1, K2 der GTO-Thyristoren T1,T2 geschaltet sind, in Längsrichtung der aus Isoliermaterial wie Aluminiumoxid bestehenden Bodenplatte B gesehen, hintereinander liegen.

A n s p r ü c h e

1. Halbleiterbauelement in Modulbauweise, bestehend aus mehreren, untereinander elektrisch verschalteten, räumlich benachbart angeordneten Halbleiterchips und äußeren Anschlußelementen zur Verbindung des Halbleiterbauelements mit der Außenwelt, dadurch gekennzeichnet, daß ein Halbleiterchip (T) mit den Eigenschaften eines Thyristors und wenigstens ein Halbleiterchip (D1,D2,D3,D4) mit den Eigenschaften einer Diode induktivitätsarm antiparallel verschaltet sind.

2. Halbleiterbauelement nach Anspruch 1, dadurch gekennzeichnet, daß die Halbleiterchips (T,D1,D2) räumlich nah nebeneinander auf einer Bodenplatte (B) aufgelötet und mit Bonddrähten (D) oder sonstigen Anschlußdrähten untereinander verschaltet sind.

3. Halbleiterbauelement nach Anspruch 1 oder 2, dadurch gekennzeichnet, daß mehrere Halbleiterchips (2.1,2.3) mit den Eigenschaften einer Diode vorgesehen sind und daß ein Anschluß wenigstens einer Diode (2.3) an ein gesondertes äußeres Anschlußelement (8) gelegt ist.

4. Halbleiterbauelement nach Anspruch 1 oder 2, dadurch gekennzeichnet, daß beide Anschlüsse wenigstens einer Diode an zwei gesonderte äußere Anschlußelemente gelegt sind.

5. Halbleiterbauelement nach wenigstens einem der vorhergehenden Ansprüche, dadurch gekennzeichnet, daß alle oder einzelne Halbleiterchips gegen die Außenwelt elektrisch isoliert aufgebaut sind.

6. Halbleiterbauelement nach wenigstens einem der vorhergehenden Ansprüche, dadurch gekennzeichnet, daß die Halbleiterchips mittels Druckkontakt kontaktiert und verschaltet sind.

7. Halbleiterbauelement nach Anspruch 1, dadurch gekennzeichnet, daß der Halbleiterchip (T) ein Rückwärts-Nicht-Sperrender-Thyristor ist.

8. Halbleiterbauelement nach Anspruch 1, dadurch gekennzeichnet, daß der Halbleiterchip (T) ein Gate-Turn-Off-Thyristor und die Diode (D3,D4) eine schnelle Diode ist.

0088924

Fig. 2

Fig. 1

Fig. 4

Fig. 5

Fig. 3

Fig. 6